# EUROPEAN PATENT SPECIFICATION

(11) **EP 3 968 705 B1**
(45) Date of publication and mention of the grant of the patent: **03.04.2024**
(21) Application number: 20809078.7
(22) Date of filing: 13.04.2020
(51) Int. Cl.: H04W 52/18, H04W 52/22, H04W 52/52

(54) **GAIN CONTROL METHOD AND DEVICE, AND COMPUTER-READABLE STORAGE MEDIUM**
VERSTÄRKUNGSTEUERUNGSVERFAHREN UND -VORRICHTUNG UND COMPUTERLESBARES SPEICHERMEDIUM
PROCÉDÉ ET DISPOSITIF DE COMMANDE DE GAIN, ET SUPPORT DE STOCKAGE LISIBLE PAR ORDINATEUR

(30) Priority: 23.05.2019 CN 201910432475
(43) Date of publication of application: 16.03.2022
(73) Proprietor: ZTE Corporation, Shenzhen, Guangdong 518057 (CN)
(72) Inventor: JI, Shuangpeng, Shenzhen, Guangdong 518057 (CN); DAN, Xiaoli, Shenzhen, Guangdong 518057 (CN)
(74) Representative: Betten & Resch
(86) International application number: PCT/CN2020/084447
(87) International publication number: WO 2020/233280

(56) References cited:
- EP-A1- 1 684 437
- EP-A2- 1 626 498
- US-A1- 2018 026 449

## Description

### TECHNICAL FIELD

The present disclosure relates to but is not limited to the technical field of communications.

### BACKGROUND

With the continuous evolution of mobile communication, the 5th Generation (5G) is favored by major operators because of its advanced technology, diversity of scenarios and flexibility of use, and will soon enter the commercial stage. User equipment (UE) is an important part of the 5G network, and its main function is to receive and transmit radio signals with base stations, and finally complete radio communication through high-level protocol processing, etc. When the UE receives radio signals, due to the mobility of its position, the diversity of the electromagnetic environment, the randomness of base station signals, etc., the received signal power is sometimes unstable, and sometimes strong and sometimes weak, that is, the dynamic range is very large. Receivers all adopt automatic gain control (AGC) schemes to realize signal tracking. However, the conventional AGC schemes can no longer meet the AGC requirements when the received power of the UE hops sharply under the 5G standard.

Patent literature EP1684437A1 discloses a reception apparatus capable of preventing saturation and sensitivity degradation of a receiver when base transceiver station transmit power control is performed and calibrating offset voltage without increasing the amount of current consumption. In this apparatus, a gain setting section estimates reception field intensity of each time slot in the next frame based on information of the reception field intensity and transmit power information which is information of the transmit power of the base transceiver station and calculates a gain set value according to the estimated reception field intensity. Again control circuit extracts a maximum gain out of the gains set by the gain setting section, uses the maximum gain as a set gain for DC offset voltage calibration and performs gain control at the gain set value corresponding to each time slot. A voltage calibration circuit performs the DC offset voltage calibration of the received signal.

While the above publication may achieve its intended purposes, there is still a need for a new and improved gain control method and device.

### SUMMARY

The invention is defined by the appended claims. An embodiment in accordance with an aspect of the present disclosure provides a gain control method.

An embodiment in accordance with another aspect of the present disclosure provides a gain control device.

An embodiment in accordance with yet another aspect of the present disclosure provides a computer-readable storage medium storing one or more programs executable by one or more processors to implement the gain control method provided by the embodiment of the present disclosure.

### BRIEF DESCRIPTION OF DRAWINGS

The accompanying drawings are used to provide a further understanding of the technical schemes of the present disclosure and constitute a part of the description. The accompanying drawings are used to explain the technical schemes of the present disclosure together with the embodiments of the present application, and do not constitute a restriction on the technical schemes of the present disclosure.
Fig. 1 is a schematic diagram in time domain of an AGC scheme in the existing technology;
Fig. 2 is a schematic diagram in time domain of an AGC scheme provided by an embodiment of the present disclosure;
Fig. 3 is a flowchart of a gain control method provided by an embodiment of the present disclosure;
Fig. 4 is a structural schematic diagram of a gain control device provided by an embodiment of the present disclosure;
Fig. 5 is a structural schematic diagram of a power estimation module provided by an embodiment of the present disclosure;
Fig. 6 is a schematic diagram of a frame structure provided by an embodiment of the present disclosure;
Fig. 7 is another flowchart of a gain control method provided by an embodiment of the present disclosure;
Fig. 8 is a flowchart of a power estimation method provided by an embodiment of the present disclosure;
Fig. 9 is a structural schematic diagram of another gain control device provided by an embodiment of the present disclosure; and
Fig. 10 is a structural schematic diagram of a computer-readable storage medium provided by an embodiment of the present disclosure.

### DETAILED DESCRIPTION

In order to make the purposes, technical schemes and advantages of the present disclosure clear, the embodiments of the present disclosure will be described hereinafter in detail with reference to the accompanying drawings. It should be noted that any combinations of embodiments and features of the embodiments of the present application without conflict are possible.

The steps shown in the flowcharts of the drawings may be performed in a computer system, such as with a set of computer-executable instructions. Moreover, although a logical order is shown in the flowcharts, the steps shown or described may be performed, in some cases, in a different order than shown or described herein.

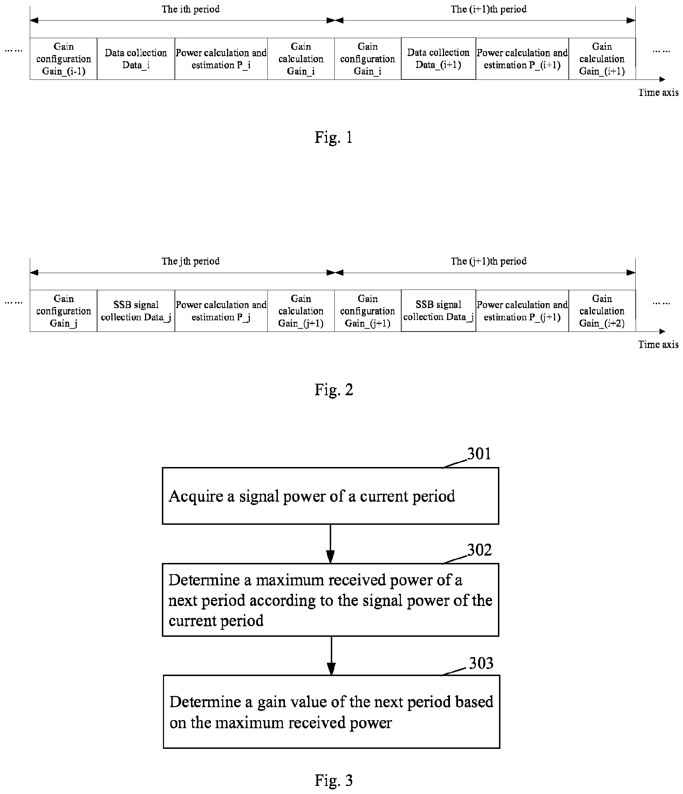

As shown in Fig. 1, which is a schematic diagram in time domain of an AGC scheme in the existing technology, the AGC processes the currently collected time domain signals and then performs gain control. Each processing period is divided into 4 stages, namely gain configuration, data collection, power calculation and gain calculation.

The gain configuration refers to the process of configuring the link gain of the current period according to the gain value calculated in the previous period; for example, in the ith period, the gain configuration value is denoted as Gain_(i-1).

The data collection refers to the collection of the received signals of the current period; for example, the data collected in the ith period is denoted as Data_i.

The power calculation refers to the calculation of the signal power of the current period according to the data sample points acquired in the data collection stage; for example, in the ith period, the power calculation value is denoted as P_i.

The gain calculation refers to the calculation, according to the signal power obtained in the power calculation stage, of the gain required for the signal power of the current period, where the gain calculation value is used for configuration in the next period; for example, in the ith period, the gain calculation value is denoted as Gain_i.

The above scheme calculates the link gain based on the signals of the current period, and then performs configuration in the next period. This scheme has a lag nature which leads to the mismatch between the configured gain and the current data in any period. For example, in the ith period in Fig. 1, the configured gain is Gain_(i-1), and the current data is Data_i.

This mismatch causes substantially no damage to signals with very small power fluctuations (e.g., less than 5 dB) in adjacent periods, so that reliable communication can still be ensured. However, if the power fluctuations in adjacent periods are very drastic (e.g., greater than 20 dB), the mismatch between the gain and data will be very serious, and will lead to link saturation, and then cause communication fluctuations or interruption.

According to an embodiment provided by the present disclosure, the UE estimates the maximum value of the received power of the next period according to the signal power of the current period, and performs radio frequency link gain control based on this maximum value, so that the gain and data can be matched.

Fig. 2 is a schematic diagram in time domain of an AGC scheme provided by an embodiment of the present disclosure. Different from the AGC schemes in the existing technology, in the current period, the power estimation of the next period is completed, and the gain value of the next period is obtained, thus ensuring that the configured gain and data in any period are exactly matched. For example, in the jth period, the gain configuration is Gain_j and the signal collection is Data_j, and the two are matched. In addition, the gain value Gain_(j+1) of the (j+1)th period is calculated in the jth period, and is used as the gain configuration of the (j+1)th period, so that the gain configuration of the (j+1)th period can match the data of the (j+1)th period.

An embodiment of the present disclosure provides a gain control method as shown in Fig. 3, which is a flowchart of the gain control method, and the method includes step 301 to step 303.

In step 301, a signal power of a current period is acquired.

In step 302, a maximum received power of a next period is determined according to the signal power of the current period.

In step 303, a gain value of the next period is determined according to the maximum received power.

The gain value of the next period is the gain value used for gain control in the next period. The gain value of the next period is subsequently configured and sent.

According to the gain control method provided by the embodiment of the present disclosure, the maximum received power of the next period is estimated in advance, and the gain value of the next period is determined based on the maximum received power, so that the signal power and the gain value can be better matched, and communication interruption caused by saturation can be avoided. The gain control method provided by the embodiment of the present disclosure can effectively solve the problem that the communication is interrupted due to the slow gain switching response of the receiving channel caused by the UE in the scenario of rapid change of the received power.

According to an embodiment provided by the present disclosure, in step 301, acquiring the signal power of the current period includes: acquiring the power of a synchronization signal block (SSB) with a maximum power in the current period. Specifically, each SSB signal in the current period is identified, the signal power of each SSB is calculated, and the SSB with the maximum power is selected, and the power of this SSB is taken as the signal power of the current period.

According to another example the power of other signals or other SSBs (not the SSB with the maximum power) can also be selected as the signal power of the current period.

According to an embodiment provided by the present disclosure, in step 302, determining the maximum received power of the next period according to the signal power of the current period includes: acquiring a power offset of a resource element (RE) of a physical downlink shared channel (PDSCH) signal in the current period relative to a RE of the SSB with the maximum power; acquiring cell configuration parameters; and determining the maximum received power of the next period according to the power of the SSB with the maximum power in the current period, the power offset, and the cell configuration parameters.

According to an embodiment provided by the present disclosure, the cell configuration parameters includes: the number of REs of the SSB, a cell configuration bandwidth, and/or the number of antennas.

According to an embodiment provided by the present disclosure, determining the maximum received power of the next period according to the power of the SSB with the maximum power in the current period, the power offset, and the cell configuration parameters includes: determining the maximum received power of the next period as S = P + K + L + M or S = P + K + L + M + N, where n is a constant used as a protection margin in power calculation and configurable according to actual use, P is the power of the SSB with the maximum power in the current period, K is the power offset, L = 101og(the number of REs of the PDSCH corresponding to the cell configuration bandwidth / the number of REs of the SSB), and M = 10log(the number of antennas).

According to an embodiment provided by the present disclosure, one period is one radio frame. It should be noted that one period may not be limited to one radio frame, for example, it may be one or more sub-frames.

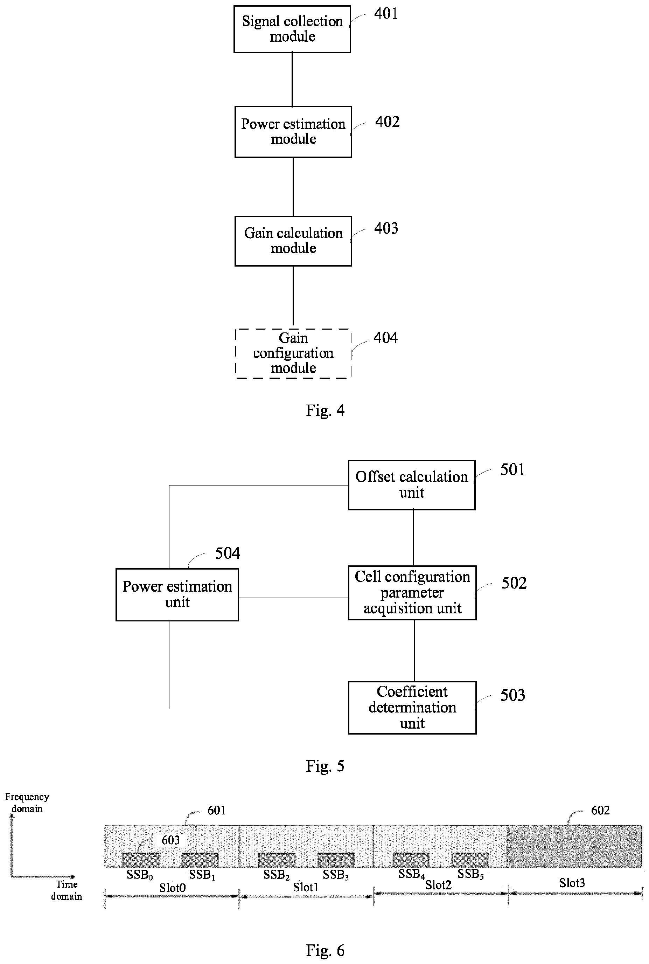

An embodiment of the present disclosure further provides a gain control device as shown in Fig. 4, which is a structural schematic diagram of the device. The device may include: a signal collection module 401, a power estimation module 402 and a gain calculation module 403.

The signal collection module 401 is configured to acquire signals of the current period and determine the signal power of the current period. For example, each SSB signal of the current frame of the UE is identified, and the signal power of each SSB is calculated at the same time, and the power of the SSB with the maximum power is taken as the signal power of the current period, and is denoted as P.

The power estimation module 402 is configured to determine the maximum received power of the next period according to the signal power of the current period.

The gain calculation module 403 is configured to determine the gain value of the next period according to the maximum received power.

According to an embodiment provided by the present disclosure, the device further includes: a gain configuration module 404 that configured to configure and send the gain value obtained by the gain calculation module 403.

According to an embodiment provided by the present disclosure, the power estimation module 402 is specifically configured to: acquire the power of the SSB with the maximum power in the current period; acquire a power offset of a RE of a PDSCH signal in the current period relative to a RE of the SSB with the maximum power; acquire the number of REs of the SSB, a cell configuration bandwidth, and the number of antennas; and determine the maximum received power of the next period according to the power of the SSB with the maximum power in the current period, the power offset, the number of REs of the SSB, the cell configuration bandwidth, and the number of antennas.

As shown in Fig. 5, which is a structural schematic diagram of the power estimation module 402 provided by an embodiment of the present disclosure, the power estimation module 402 includes: an offset calculation unit 501, a cell configuration parameter acquisition unit 502, a coefficient determination unit 503, and a power estimation unit 504.

The offset calculation unit 501 is configured to calculate the power offset of each RE of the PDSCH relative to the SSB with the maximum power, and obtain the offset coefficient K.

The cell configuration parameter acquisition unit 502 is configured to acquire configuration parameters of the current radio cell, such as the number of resource blocks (RBs) of the SSB, the cell configuration bandwidth, and/or the number of antennas.

The coefficient determination unit 503 is configured to calculate a RB conversion coefficient L according to the number of RBs of the SSB and the cell configuration bandwidth; and also calculate the maximum gain in beam forming according to the number of antennas in the cell configuration to obtain the gain factor M, where the RB conversion coefficient L = 101og(the number of RBs of the PDSCH corresponding to the cell configuration bandwidth / the number of SSBs) and the gain factor M = 10log(the number of antennas).

The power estimation unit 504 is configured to determine the maximum signal power S of the next period according to the information obtained by the above units, where S = P + K + L + M, or S = P + K + L + M + N, where n is a constant and can be set as needed.

According to the maximum signal power S of the next period, when the next period arrives, the gain that matches the signal power is configured, thus ensuring that the signal and the gain factor are matched.

A conventional AGC scheme in the existing technology performs an adjustment in the next period according to the signal power of the current period, and thus cannot guarantee the effective matching between the gain and the signal power at any moment, thus leading to fast-hopping signals prone to link saturation. The gain control device provided by the embodiment of the present disclosure can estimate the maximum received signal power of the next period based on the signal power of the current period, and adjust the gain of the next period accordingly, so that the communication will not be interrupted due to the saturation of the received signal in the next period. The scheme provided by this embodiment is equivalent to predicting the power of the next period in advance, so that an appropriate link gain can be accurately calculated.

Due to the predictability of the gain control method and device provided by the embodiments of the present disclosure, they can adapt to any rapidly fluctuating received signal.

To further illustrate the present disclosure, the following illustrative example takes a certain frame structure in the NR protocol as an example. As shown in Fig. 6, which is a schematic diagram of a typical 5G frame structure, the frame structure includes 4 slots, namely SlotO to Slot3 in order.

601 denotes downlink slots, and there are 3 slots in each frame, namely SlotO to Slot2, which are configured to transmit the received signals of the UE. 602 denotes an uplink slot, and there is 1 slot in each frame, namely Slot3, which is configured to transmit the transmitted signals of the UE. 603 denotes the position of the SSB signal, and there are 6 SSBs contained, namely SSBO to SSB5 in order, which are located at some 4 symbols in the time domain and the first 20 RBs in the frequency domain.

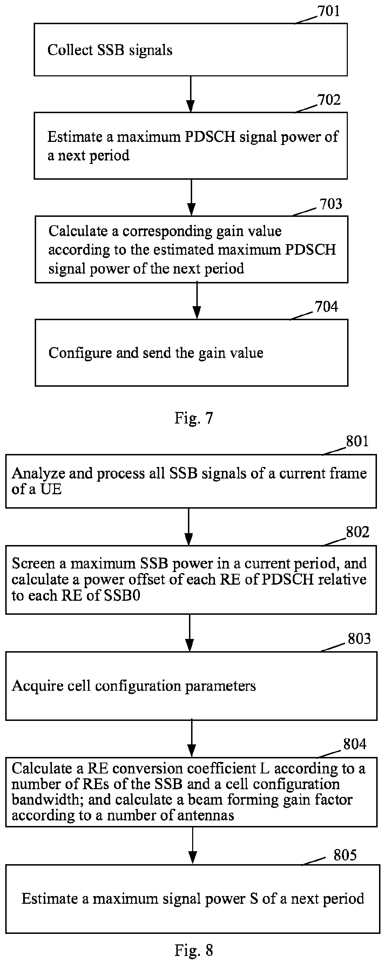

To facilitate the description of the AGC processing flow mentioned in the present disclosure, the following description is provided in conjunction with Fig. 6 and Fig. 7. As shown in Fig. 7, which is another flowchart of the gain control method provided by the embodiment of the present disclosure, the method includes steps 701 to 704.

In step 701, in the NR protocol, all SSB signals in the above frame structure are collected in the time domain.

In step 702, all the collected SSB data are subjected to Fourier transform to calculate the power of the SSBs in the first 20 RBs, and the one with the maximum power, such as SSBO, is screened out, and the power of SSBO is denoted as P. The PDSCH signal of the next period is then estimated, where the power offset of the PDSCH relative to SSBO, the beam forming gain factor, the RB conversion coefficient, etc., are taken into consideration at the same time, so as to estimate the maximum PDSCH signal power for the next period.

In step 703, according to the estimated maximum PDSCH signal power for the next period, the corresponding gain value is calculated.

In step 704, the gain value is configured and sent.

The implementation of power estimation in step 702 is illustrated with an example as follows with reference to Fig. 6 and Fig. 8. As shown in Fig. 8, which is a flowchart of the power estimation method provided by the embodiment of the present disclosure, the method includes steps 801 to 805.

In step 801, a baseband processing unit analyzes and processes all SSB signals of the current frame of the UE.

In step 802, the baseband processing unit performs time-domain data collection according to the time-domain data of the SSBs, and then performs Fourier transform, and then performs statistical calculation on the signals of the first 20 RBs to obtain the power of the SSBs, and screens the maximum SSB power in the current period, such as SSBO, with the magnitude of the power denoted as P(dBm). At the same time, the power offset of each RE of the PDSCH relative to each RE of SSBO is calculated, that is, how much higher the power of the PDSCH is than that of SSBO on each RE, so as to obtain an offset factor K (in dB).

In practice, the range of K is -15≤K≤12. In this example, K is 0 dB, that is, there is no offset between the PDSCH and the SSB.

In step 803, cell configuration parameters in the current cell are acquired, which may include, the number of RBs (e.g., 20 RBs for the SSB and 273 RBs for the PDSCH), the configuration bandwidth (e.g., 100 MHz), the number of antennas (e.g., 64 antennas), etc.

In step 804, the RB conversion coefficient L is calculated according to the number of RBs of the SSB and the cell configuration bandwidth; and also, a beam forming gain factor M (dB) is calculated according to the number of antennas.

In this example, SSBO contains 20 RBs, and PDSCH contains 273 RBs when PDSCH is full of RBs, so the power conversion coefficient L = 10*log(273/20) = 11.35 dB. In this example, the beam forming gain factor of the 64 antennas is M = 10*log(64) = 18 dB.

In step 805, the maximum signal power S for the next period is estimated, where S = P + K + L + M + N = P + 0 + 11.3 + 18 + 6 = P + 35.3 (dBm). N is a constant, and the value of N in this example is 6. However, the embodiments of the present disclosure are not limited to this example, and a value of N is configurable as needed. Alternatively, S = P + K + L + M = P + 0 + 11.3 + 18 = P + 29.3 (dBm).

The gain control method provided by the embodiments of the present disclosure may acquire the maximum signal power for the next period, and then select an appropriate gain level according to the power, which can not only solve the problem of slow hardware response caused by fast hopping of the received power of the UE, but also reduce the frequency of adjustment to the greatest extent and save resource overhead.

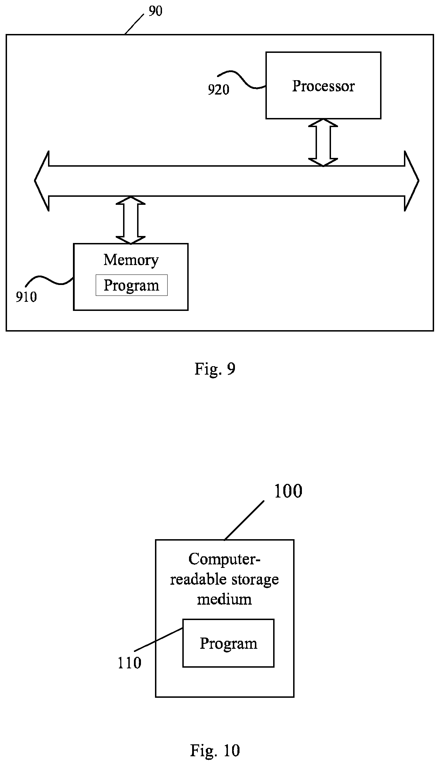

As shown in Fig. 9, which is a structural schematic diagram of another gain control device 90 provided by an embodiment of the present disclosure, the device may include a memory 910 and a processor 920, where the memory 910 stores a program which, when read and executed by the processor 920, causes the processor 920 to perform the gain control method provided by the embodiments of the present disclosure.

As shown in Fig. 10, which is a structural schematic diagram of a computer-readable storage medium 100 provided by an embodiment of the present disclosure, the computer-readable storage medium 100 stores one or more programs 110, where the one or more programs 110 are executable by one or more processors to implement the gain control method provided by the embodiments of the present disclosure.

It can be understood by those having ordinary skills in the art that all or some of the steps of the methods, systems and functional modules/units in the devices disclosed above can be implemented as software, firmware, hardware and appropriate combinations thereof. In the hardware implementation, the division between functional modules/units mentioned in the above description does not necessarily correspond to the division of physical components; for example, a physical component may have multiple functions, or a function or step may be performed cooperatively by several physical components. Some or all of the components may be implemented as software executed by a processor, such as a digital signal processor or a microprocessor, or as hardware, or as an integrated circuit, such as an application specific integrated circuit. Such software can be distributed on computer-readable media, which can include computer storage media (or non-transitory media) and communication media (or transitory media). As well known to those having ordinary skills in the art, the term computer-readable storage medium includes volatile and nonvolatile, removable and non-removable media implemented in any method or technology for storing information, such as computer-readable instructions, data structures, program modules or other data. A computer storage medium includes, but is not limited to, RAM, ROM, EEPROM, flash memory or other memory technologies, CD-ROM, digital versatile disk (DVD) or other optical disk storage, cassettes, magnetic tapes, magnetic disk storage or other magnetic storage devices, or any other medium that can be configured to store desired information and can be accessed by a computer. Furthermore, it is well known to those having ordinary skills in the art that communication media typically contain computer-readable instructions, data structures, program modules or other data in a modulated data signal such as a carrier wave or other transmission mechanism, and can include any information delivery media.

## Claims

1. A gain control method, comprising:
acquiring a signal power of a current period (301);
determining a maximum received power of a next period according to the signal power of the current period (302); and
determining a gain value of the next period according to the maximum received power of the next period (303) **characterized in that**,
acquiring the signal power of the current period comprises:
acquiring a power of a synchronization signal block with a maximum power in the current period.

2. The method of claim 1, wherein determining the maximum received power of the next period according to the signal power of the current period comprises:
acquiring a power offset of a resource element of a physical downlink shared channel signal in the current period relative to a resource element of the synchronization signal block with the maximum power;
acquiring cell configuration parameters; and
determining the maximum received power of the next period according to the power of the synchronization signal block with the maximum power in the current period, the power offset, and the cell configuration parameters.

3. The method of claim 2, wherein the cell configuration parameters comprise: a number of resource elements of the synchronization signal block, a cell configuration bandwidth, and a number of antennas.

4. The method of claim 3, wherein determining the maximum received power of the next period according to the power of the synchronization signal block with the maximum power in the current period, the power offset, and the cell configuration parameters comprises:
determining the maximum received power of the next period as S = P + K + L + M or S = P + K + L + M + N,
wherein the N is a constant, the p is the power of the synchronization signal block with the maximum power in the current period, the k is the power offset, the L = 10log(the number of resource elements of the physical downlink shared channel signal corresponding to the cell configuration bandwidth/the number of resource elements of the synchronization signal block), and the M = 10log(the number of antennas).

5. The method of any one of claims 1 to 4, wherein one period is one radio frame.

6. A gain control device, comprising:
a signal collection module (401) configured to acquire a signal power of a current period;
a power estimation module (402) configured to determine a maximum received power of a next period according to the signal power of the current period; and
a gain calculation module (403) configured to determine a gain value of the next period according to the maximum received power of the next period;
**characterized in that**,
the signal collection module is configured to:
acquire a power of a synchronization signal block with a maximum power in the current period.

7. The device of claim 6, wherein the power estimation module is configured to:
acquire a power offset of a resource element of a physical downlink shared channel signal in the current period relative to a resource element of the synchronization signal block with the maximum power;
acquire cell configuration parameters; and
determine the maximum received power of the next period according to the power of the synchronization signal block with the maximum power in the current period, the power offset, and the cell configuration parameters.

8. The device of claim 7, wherein the cell configuration parameters comprise: a number of resource elements of the synchronization signal block, a cell configuration bandwidth, and a number of antennas.

9. The device of claim 8, wherein the power estimation module is configured to:
determine the maximum received power of the next period as S = P + K + L + M or S = P + K + L + M + N,
wherein the N is a constant, the p is the power of the synchronization signal block with the maximum power in the current period, the k is the power offset, the L = 10log(the number of resource elements of the physical downlink shared channel signal corresponding to the cell configuration bandwidth/the number of resource elements of the synchronization signal block), and the M = 10log(the number of antennas).

10. The device of any one of claims 6 to 9, wherein one period is one radio frame.

11. A gain control device comprising a memory (910) and a processor (920), wherein the memory (910) stores a computer program which, when read and executed by the processor (920), causes the processor (920) to perform the gain control method of any one of claims 1 to 5.

12. A computer-readable storage medium (100) storing one or more programs (110) executable by one or more processors to implement the gain control method of any one of claims 1 to 5.

## Patentansprüche

1. Verstärkungsteuerungsverfahren, umfassend:
Erfassen (301) einer Signalleistung einer aktuellen Periode;
Bestimmen (302) einer maximalen empfangenen Leistung einer nächsten Periode gemäß der Signalleistung der aktuellen Periode; und
Bestimmen (303) eines Verstärkungwerts der nächsten Periode gemäß der maximalen empfangenen Leistung der nächsten Periode, **dadurch gekennzeichnet, dass**
das Erfassen der Signalleistung der aktuellen Periode umfasst:
Erfassen einer Leistung eines Signalsynchronisationsblocks mit einer maximalen Leistung in der aktuellen Periode.

2. Verfahren nach Anspruch 1, wobei das Bestimmen der maximalen empfangenen Leistung der nächsten Periode gemäß der Signalleistung der aktuellen Periode umfasst:
Erfassen eines Leistungs-Offsets eines Ressourcenelements eines physikalischen Downlink-Shared-Channel-Signals in der aktuellen Periode, das relativ zu einem Ressourcenelement des Signalsynchronisationsblocks mit maximaler Leistung ist;
Erfassen von Zellenkonfigurationsparametern; und
Bestimmen der maximalen empfangenen Leistung der nächsten Periode gemäß der Leistung des Signalsynchronisationsblocks mit der maximalen Leistung in der aktuellen Periode, dem Leistungs-Offset, und den Zellenkonfigurationsparametern.

3. Verfahren nach Anspruch 2, wobei die Zellenkonfigurationsparameter umfassen: eine Anzahl von Ressourcenelementen des Signalsynchronisationsblocks, eine Zellenkonfigurationsbandbreite, und eine Anzahl von Antennen.

4. Verfahren nach Anspruch 3, wobei das Bestimmen der maximalen empfangenen Leistung der nächsten Periode gemäß der Leistung des Signalsynchronisationsblocks mit der maximalen Leistung in der aktuellen Periode, dem Leistungs-Offset, und den Zellenkonfigurationsparametern umfasst:
Bestimmen der maximalen empfangenen Leistung der nächsten Periode als S = P + K + L + M oder S = P + K + L + M + N,
wobei N eine Konstante ist, das p die Leistung des Signalsynchronisationsblocks mit der maximalen Leistung in der aktuellen Periode ist, das k das Leistungs-Offset ist, das L = 10log(die Anzahl von Ressourcenelementen des physikalischen Downlink-Shared-Channel-Signals entsprechend der Zellenkonfigurationsbandbreite/der Anzahl von Ressourcenelementen des Signalsynchronisationsblocks), und das M = 10log(die Anzahl von Antennen).

5. Verfahren nach einem der Ansprüche 1 bis 4, wobei eine Periode ein Funkframe ist.

6. Verstärkungsteuerungsvorrichtung umfassend:
ein Signalerfassungsmodul (401), dazu konfiguriert, eine Signalleistung einer aktuellen Periode zu erfassen;
ein Leistungsschätzungsmodul (402), dazu konfiguriert, eine maximal empfangene Leistung einer nächsten Periode gemäß der Signalleistung der aktuellen Periode zu bestimmen; und
ein Verstärkungberechnungsmodul (403), dazu konfiguriert, einen Verstärkungwert der nächsten Periode gemäß der maximal empfangenen Leistung der nächsten Periode zu bestimmen;
**dadurch gekennzeichnet, dass**
das Signalerfassungsmodul dazu konfiguriert ist:
eine Leistung eines Signalsynchronisationsblocks mit einer maximalen Leistung in der aktuellen Periode zu erfassen.

7. Vorrichtung nach Anspruch 6, wobei das Leistungsschätzungsmodul dazu konfiguriert ist:
ein Leistungs-Offset eines Ressourcenelements eines physikalischen Downlink-Shared-Channel-Signals in der aktuellen Periode, das relativ zu einem Ressourcenelement des Signalsynchronisationsblocks mit maximaler Leistung ist, zu erfassen;
Zellenkonfigurationsparameter zu erfassen; und
die maximale empfangene Leistung der nächsten Periode gemäß der Leistung des Signalsynchronisationsblocks mit der maximalen Leistung in der aktuellen Periode, dem Leistungs-Offset, und den Zellenkonfigurationsparametern zu bestimmen.

8. Vorrichtung nach Anspruch 7, wobei die Zellenkonfigurationsparameter umfassen: eine Anzahl von Ressourcenelementen des Signalsynchronisationsblocks, eine Zellenkonfigurationsbandbreite, und eine Anzahl von Antennen.

9. Vorrichtung nach Anspruch 8, wobei das Leistungsschätzungsmodul dazu konfiguriert ist:
die maximale empfange Leistung der nächsten Periode als S = P + K + L + M oder S = P + K + L + M + N zu bestimmen,
wobei N eine Konstante ist, das p die Leistung des Signalsynchronisationsblocks mit der maximalen Leistung in der aktuellen Periode ist, das k das Leistungs-Offset ist, das L = 10log(die Anzahl von Ressourcenelementen des physikalischen Downlink-Shared-Channel-Signals entsprechend der Zellenkonfigurationsbandbreite/der Anzahl von Ressourcenelementen des Signalsynchronisationsblocks), und das M = 10log(die Anzahl von Antennen).

10. Vorrichtung nach einem der Ansprüche 6 bis 9, wobei eine Periode ein Funkframe ist.

11. Verstärkungsteuerungsvorrichtung, umfassend einen Speicher (910) und einen Prozessor (920), wobei der Speicher (910) ein Computerprogramm speichert, das, wenn es von dem Prozessor (920) gelesen und ausgeführt wird, den Prozessor (920) dazu veranlasst, das Verstärkungsteuerungsverfahren nach einem der Ansprüche 1 bis 5 durchzuführen.

12. Computerlesbares Speichermedium (100), das eines oder mehrere Programme (110) speichert, die durch einen oder mehrere Prozessoren ausführbar sind, um das Verstärkungsteuerungsverfahren nach einem der Ansprüche 1 bis 5 zu implementieren.

## Revendications

1. Un procédé de commande de gain, comprenant :
le fait d'acquérir une puissance de signal d'une période en cours (301) ;
le fait de déterminer une puissance reçue maximale d'une période suivante en fonction de la puissance du signal de la période en cours (302) ; et
le fait de déterminer une valeur de gain de la période suivante en fonction de la puissance reçue maximale de la période suivante (303) **caractérisé en ce que**,
l'acquisition de la puissance du signal de la période en cours comprend :
le fait d'acquérir une puissance d'un bloc de signal de synchronisation avec une puissance maximale dans la période en cours.

2. Le procédé selon la revendication 1, dans lequel la détermination de la puissance reçue maximale de la période suivante en fonction de la puissance du signal de la période en cours comprend :
le fait d'acquérir un décalage de puissance d'un élément de ressource d'un signal de canal partagé de liaison descendante physique dans la période en cours par rapport à un élément de ressource du bloc de signal de synchronisation avec la puissance maximale ;
le fait d'acquérir des paramètres de configuration de cellules ; et
le fait de déterminer la puissance reçue maximale de la période suivante en fonction de la puissance du bloc de signal de synchronisation avec la puissance maximale dans la période en cours, du décalage de puissance et des paramètres de configuration de cellule.

3. Le procédé selon la revendication 2, dans lequel les paramètres de configuration de cellule comprennent :
un certain nombre d'éléments de ressources du bloc de signal de synchronisation, une bande passante de configuration de cellule et un certain nombre d'antennes.

4. Le procédé selon la revendication 3, dans lequel la détermination de la puissance reçue maximale de la période suivante en fonction de la puissance du bloc de signal de synchronisation avec la puissance maximale dans la période en cours, le décalage de puissance et les paramètres de configuration de cellule comprend :
le fait de déterminer la puissance reçue maximale de la période suivante comme étant S = P + K + L + M, ou S = P + K + L + M + N,
le N étant une constante, le p étant la puissance du bloc de signal de synchronisation avec la puissance maximale dans la période en cours, le k étant le décalage de puissance, le L = 10log (le nombre d'éléments de ressources du signal de canal partagé de liaison descendante physique correspondant à la bande passante de configuration de cellule/le nombre d'éléments de ressource du bloc de signal de synchronisation), et le M = 10log(le nombre d'antennes).

5. Le procédé selon l'une quelconque des revendications 1 à 4, dans lequel une période est une trame radio.

6. Un dispositif de commande de gain, comprenant :
un module (401) de collecte de signaux configuré pour acquérir une puissance de signal d'une période actuelle ;
un module (402) d'estimation de puissance configuré pour déterminer une puissance reçue maximale d'une période suivante en fonction de la puissance du signal de la période actuelle ; et
un module (403) de calcul de gain configuré pour déterminer une valeur de gain de la période suivante en fonction de la puissance reçue maximale de la période suivante ;
**caractérisé en ce que**
le module de collecte de signaux est configuré pour :
acquérir une puissance d'un bloc de signal de synchronisation avec une puissance maximale dans la période en cours.

7. Le dispositif selon la revendication 6, dans lequel le module d'estimation de puissance est configuré pour :
acquérir un décalage de puissance d'un élément de ressource d'un signal de canal partagé de liaison descendante physique dans la période actuelle par rapport à un élément de ressource du bloc de signal de synchronisation avec la puissance maximale ;
acquérir des paramètres de configuration de cellule ; et
déterminer la puissance reçue maximale de la période suivante en fonction de la puissance du bloc de signal de synchronisation avec la puissance maximale dans la période actuelle, le décalage de puissance et les paramètres de configuration de cellule.

8. Le dispositif selon la revendication 7, dans lequel les paramètres de configuration de cellule comprennent : un certain nombre d'éléments de ressources du bloc de signal de synchronisation, une bande passante de configuration de cellule et un certain nombre d'antennes.

9. Le dispositif selon la revendication 8, dans lequel le module d'estimation de puissance est configuré pour :
déterminer la puissance reçue maximale de la période suivante comme étant S = P + K + L + M, ou S = P + K + L + M + N,
le N étant une constante, le p étant la puissance du bloc de signal de synchronisation avec la puissance maximale dans la période en cours, le k étant le décalage de puissance, le L = 10log (le nombre d'éléments de ressources du signal de canal partagé de liaison descendante physique correspondant à la bande passante de configuration de cellule/le nombre d'éléments de ressource du bloc de signal de synchronisation), et le M = 10log(le nombre d'antennes).

10. Le dispositif selon l'une quelconque des revendications 6 à 9, dans lequel une période est une trame radio.

11. Un dispositif de commande de gain comprenant une mémoire (910) et un processeur (920), la mémoire (910) stockant un programme informatique qui, lorsqu'il est lu et exécuté par le processeur (920), amène le processeur (920) à mettre en oeuvre le procédé de commande de gain selon l'une quelconque des revendications 1 à 5.

12. Un support de stockage lisible par ordinateur (100) stockant un ou plusieurs programmes (110) exécutables par un ou plusieurs processeurs pour mettre en oeuvre le procédé de commande de gain de l'une quelconque des revendications 1 à 5.
